# EUROPÄISCHE PATENTANMELDUNG

(11) **EP 2 034 328 A1**
(43) Veröffentlichungstag der Anmeldung: **11.03.2009**
(21) Anmeldenummer: 08105091.6
(22) Anmeldetag: 21.08.2008
(51) Int. Cl.: G01S 7/03, G01S 13/93

(54) **Radarsensor**

(30) Priorität: 05.09.2007 DE 102007042173
(71) Anmelder: Hella KGaA Hueck & Co., 59552 Lippstadt (DE)
(72) Erfinder: Hoffmann, Andreas, 59755 Arnsberg (DE); Krömer, Ralf, 59510 Lippetal (DE); Philipp, Dietmar, 59597 Erwitte (DE)

(57) **Zusammenfassung**

Die Erfindung betrifft einen Radarsensor, bei dem mindestens zwei Leiterplatten angeordnet sind, wobei die Leiterplatten elektrisch miteinander verbindbar sind. Die Leiterplatten sind an einem metallischen Träger lösbar befestigt und mit diesem in einem Gehäuse angeordnet, das mit einem Deckel verschließbar ist. Der Deckel ist aus Metall gefertigt und bildet mit dem Träger in montiertem Zustand ein Labyrinth. Das Gehäuse ist aus Kunststoff. Hierdurch kann der Radarsensor einerseits flexibel ausgestaltet und an unterschiedliche Verwendungen angepasst werden. Andererseits ist er demontierbar.

## Beschreibung

Die Erfindung betrifft einen Radarsensor gemäß dem Oberbegriff des Anspruchs 1.

Radarsensoren als solche sind bekannt; sie werden z.B. in Kraftfahrzeugen eingesetzt, um Abstände zu bewegten und/oder ortsfesten Gegenständen zu bestimmen. Hierfür sind die Radarsensoren mit entsprechender Ausrichtung in einem vorderen und/oder einem hinteren Bereich eines Kraftfahrzeugs eingebaut.

Die DE 10 2005 036 632 A1 beschreibt einen Radarsensor, bei dem eine Radarantenne, die auf einer Leiterplatte angeordnet ist, mittels eines leitenden Klebers und eines Epoxid- Klebers in einem metallischen Gehäuse befestigt ist. Nachteil dieses bekannten Radarsensors ist, dass die Radarantenne praktisch nicht vom Gehäuse gelöst werden kann und dass leitende Kleber relativ teuer sind. Die Montage ist aufwändig.

Aus der DE 199 63 003 A1 ist ein Radarsensor bekannt, bei dem Strahlerelemente auf einer Leiterplatte angeordnet sind. Die Leiterplatte ist am Boden eines Gehäuses befestigt. In ein Radom sind Leiterbahnen eingelassen. Dieser Radarsensor baut sehr hoch; eine Steckverbindung unter Berücksichtigung der elektromagnetischen Verträglichkeit ist aufwändig.

Aufgabe der Erfindung ist es, einen Radarsensor zur Verfügung zu stellen, der einfach und preiswert herzustellen ist und der einfach an wechselnde Anforderungen angepasst werden kann. Hierbei soll die elektromagnetische Verträglichkeit gewährleistet sein.

Die Aufgabe ist durch die Merkmale des Anspruchs 1 gelöst. Die Verteilung von Antenne einerseits und zumindest einem Teil von elektrischen Bauteilen andererseits auf mindestens zwei Leiterplatten erlaubt eine flexible Anpassung des Radarsensors mittels Baukastenprinzip an unterschiedliche Anforderungen. Die Leiterplatten selbst können für die jeweilige Funktion und in ihren Abmessungen optimiert werden.
Die Leiterplatten sind auf einem metallischen Träger lösbar befestigt. Dies erleichtert die Montage. Weiterhin ist eine Demontage z.B. für eine Fehleranalyse oder im Fall einer Entsorgung möglich. Der metallische Träger gewährleistet in Verbindung mit dem metallischen Deckel die erforderliche Abschirmung und somit die elektromagnetische Verträglichkeit.
Das Gehäuse ist aus Kunststoff und daher einfach herstellbar. Hierbei können gleichzeitig erforderliche Anschlüsse für z.B. Stecker und Druckausgleich angeformt werden, wobei Anpassungen mit verhältnismäßig geringem Aufwand möglich sind. Eine der Antenne zugewandte Seite des Gehäuses ist als Radom entsprechend den Anforderungen ausgeführt.

Ein Druckausgleichselement gewährleistet weitgehend konstante Druckverhältnisse innerhalb des Gehäuses auch bei extremen Plus- oder Minus- Temperaturen, so dass Deformierungen des Gehäuses und besonders des Radoms vermieden werden. Das Druckausgleichselement ist vorzugsweise als Membran ausgeführt.

Wenn das Druckausgleichselement mit einer Kappe abgedeckt ist, ist eine hohe Dichtheit gegen Hochdruck- oder Dampfstrahl nach Schutzklasse 1P6K9K gewährleistet. Hierbei ist die Abdeckung jedoch nicht luftdicht.

An dem Gehäuse ist eine elektrische Buchse mit entsprechenden Kontaktdrähten ausgebildet, wobei diese durch Einpresskontakte mit der zweiten Leiterplatte elektrisch verbindbar sind. Dies erfüllt einerseits die Forderung der Fahrzeughersteller nach einfachem elektrischem Anschluss durch Steckverbinder, wobei die Buchse entsprechend den individuellen Spezifikationen der Fahrzeughersteller angepasst werden kann. Andererseits gewährleisten die Einpresskontakte eine einfach Montage ohne Löten und sicheren elektrischen Kontakt. Eine zerstörungsfreie Demontage ist möglich.

An dem Träger ausgebildete Kammern zur Aufnahme von auf den Leiterplatten angeordneten elektrischen Baugruppen gewährleisten deren gegenseitige Abschirmung mit geringem Aufwand.

Die elektrische Verbindung der Leiterplatten mittels Steckverbindung erleichtert die Montage, weil hierfür nicht gelötet werden muss; die Steckerteile werden in einem Arbeitsgang mit den Bauteilen auf den Leiterplatten befestigt und verlötet.
Eine Toleranz ausgleichende Steckverbindung bewirkt hierbei, dass die Fertigung der Leiterplatten mit größeren Toleranzen möglich und daher preiswerter ist.

Die elektrische Verbindung der Leiterplatten mittels Stiftleiste ist eine andere günstige Alternative.

Schrauben gewährleisten eine sichere lösbare Befestigung, sind einfach zu montieren und preiswert.

Durch die Verbindung des Deckels über die Buchse mit einer elektrischen Masse ist die elektromagnetische Verträglichkeit gesichert.

Anhand der beigefügten Zeichnungen wird die Erfindung nachfolgend näher erläutert. Dabei zeigt:
- Fig. 1: eine Explosionszeichnung eines erfindungsgemäßen Radarsensors,
- Fig. 2: eine perspektivische Ansicht eines Gehäuses als Detail,
- Fig. 3: eine perspektivische Ansicht auf zwei Seiten eines Halters als Detail,
- Fig. 4: eine perspektivische Ansicht eines Deckels als Detail und
- Fig. 5: eine Explosionszeichnung einer alternativen Ausführung des Radarsensors.

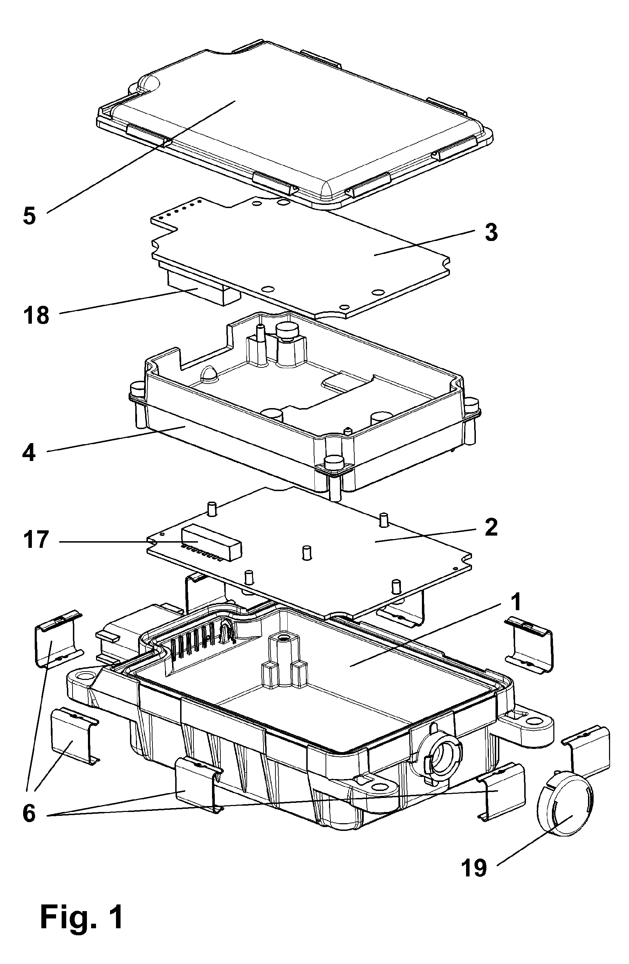

Wie aus Figur 1 ersichtlich umfasst ein Radarsensor ein Gehäuse 1, eine erste Leiterplatte 2 mit einer Antenne, eine zweite Leiterplatte 3, einen Halter 4 und einen Deckel 5. In montiertem Zustand ist der Deckel 5 durch eine Vielzahl von Federklammern 6 auf dem Gehäuse 1 gehalten. Die Leiterplatten 2, 3 sind an zwei gegenüberliegenden Seiten des Halters 4 und dieser in dem Gehäuse 1 mittels nicht dargestellter Schrauben befestigt.

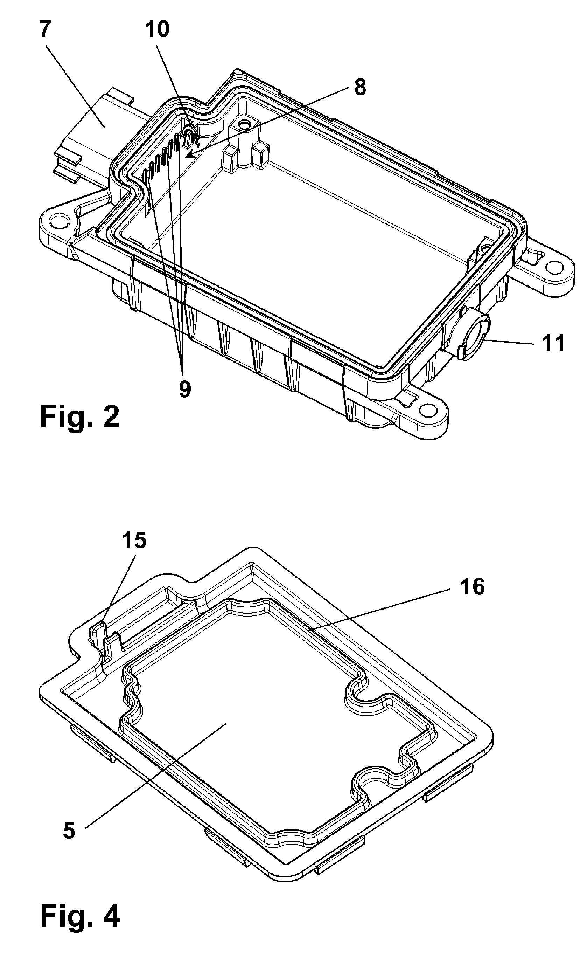

Das Gehäuse 1 nach Figur 2 ist im Wesentlichen quaderförmig, wobei eine obere Seite, die eine Hauptfläche bildet, offen ist. Zur Stabilisierung ist der obere Rand des Gehäuses 1 nach außen verstärkt; weiterhin sind Längsseiten in einem mittleren Bereich außen mit Rippen versehen. In den oberen Rand ist eine Dichtung derart eingelegt oder ausgebildet, dass sie gegen das Gehäuse 1 und den montierten Deckel 5 dicht abschließt. Ein Gehäuseboden ist weitgehend eben und als Radom ausgeführt. In den Ecken des Gehäuses 1 sind vom Gehäuseboden ausgehende Blöcke zur Lagerung des Halters 4 ausgebildet. Jeder der Blöcke weist eine Bohrung zur Aufnahme eines Schraubenschafts auf.

An einer Breitseite des Gehäuses 1 ist außen eine Buchse 7 angeformt. Im Bereich der Buchse 7 weist das Gehäuse 1 im oberen Bereich eine in etwa balkenförmige Ausbuchtung 8 auf, in der Kontaktdrähte 9 aus der Buchse 7 enden. Die Kontaktdrähte 9 ragen in etwa senkrecht aus der unteren, die Ausbuchtung 8 begrenzenden Fläche und sind hier als Einpresskontakte ausgeführt. Weiterhin ist hier ein Massekontakt 10 angeordnet, der Omega- förmig über einen in der Ausbuchtung 8 gebildeten Steg gelegt ist. Zur Verstärkung sind außen zwischen der Ausbuchtung 8 und der angrenzenden Gehäuseseite Rippen angeordnet.

An einer der Buchse 7 gegenüberliegenden Seite des Gehäuses ist zentrisch ein nach außen weisender Stutzen 11 mit rundem Querschnitt angeordnet. Der Stutzen 11 ist durchgängig zum Inneren des Gehäuses 1 hohl, wobei der Innendurchmesser in einer Stufe nach außen vergrößert ist. Der Stutzen 11 ist innen durch eine Teflon- Membran als Druckausgleichselement verschlossen. Hierfür ist die Teflon- Membran gegen die Stufe abgestützt und durch eine federnde Klemmscheibe gehalten. Zur Abdichtung ist zwischen der Membran und der Klemmscheibe ein O- Ring angeordnet. Falls erforderlich ist der Stutzen an seinem äußeren Ende durch eine Kappe 19 Hochdruckstrahl- und Dampfstrahl- dicht (aber nicht luftdicht) nach 1P6K9 verschlossen.

Damit der Radarsensor an einem Fahrzeug befestigt werden kann, sind außen an dem Gehäuse 1 entsprechende Arme mit Durchgangsbohrungen ausgebildet.

Das Gehäuse 1 ist aus Kunststoff im Spritzgußverfahren hergestellt, wobei die Kontaktdrähte 9 gleichzeitig eingearbeitet sind.

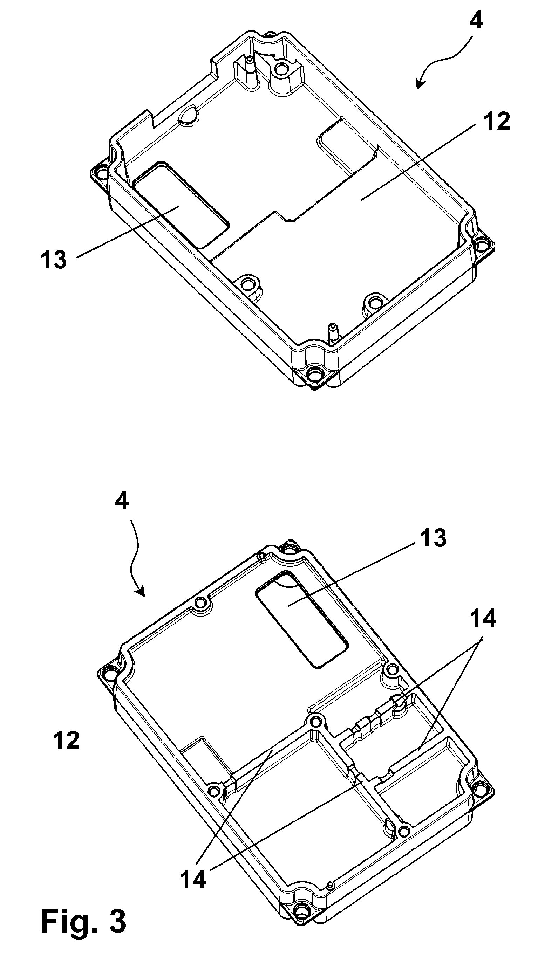

Der Halter 4, der in der Figur 3 als Detail dargestellt ist, ist einteilig aus Metall, z.B. Aluminium- Druckguss, hergestellt. Seine äußeren Abmessungen sind auf das Gehäuse 1 abgestimmt, so dass er einschließlich der montierten Leiterplatten 2, 3 mit Spiel in dieses passt. Der Halter umfasst einen weitgehend rechteckigen Rahmen mit einem darin angeordneten Boden 12, der mit einer Stufe ausgebildet ist. Auf diese Weise sind jeweils auf beiden Seiten des Bodens 12 zwei Abschnitte unterschiedlicher Höhen zwischen dem Boden und einer durch die Ränder des Rahmens bestimmten Ebene gebildet. Die Stufe ist geschlossen und entsprechend den Bauteilen der Leiterplatten 2, 3 angeordnet.

Parallel zu einer Längsseite des Halters 4 und ausgehend von einer Ecke ist in dem Boden 12 eine längliche Öffnung 13 mit rechteckigem Querschnitt eingelassen. Zur gegenseitigen Abschirmung von Bauteilgruppen der ersten Leiterplatte 2 sind auf dem Boden 12 Rippen 14 ausgebildet, die in Verbindung mit dem Boden 12 und der montierten ersten Leiterplatte 2 Kammern bilden. Hierbei sind die Rippen 14 auf einer ersten Seite des Bodens 12, die in montiertem Zustand direkt benachbart zu der ersten Leiterplatte 2 ist, im Bereich der größeren Höhe angeordnet.

Der Deckel 5, dessen Innenseite in der Figur 4 deutlicher dargestellt ist, entspricht in seinem Außenumfang dem oberen Rand des Gehäuses 1. Er ist aus Metall, z.B. Aluminium- Druckguss hergestellt. In einem Bereich, der der Ausbuchtung 8 des Gehäuses 1 entspricht, ist ein klammerartiger Kontaktanschluss 15 ausgebildet, der im montierten Zustand über den Massekontakt 10 greift und mit diesem in festem Kontakt ist. Auf der Innenfläche des Deckels 5 ist ein endloser Umlaufsteg 16 so angeordnet, dass er mit geringem Spiel in den Rahmen des Halters 4 passt; der Verlauf des Umlaufstegs 16 ist hierbei derart, dass sich Schraubenköpfe zwischen ihm und einem äußeren Rand des Deckels 5 befinden. Der Deckel 5 mit dem Umlaufsteg 16 und der Rahmen 4 sind so aufeinander abgestimmt, dass in montiertem Zustand ein Labyrinth zur sicheren EMV- Abschirmung gewährleistet ist.

Die beiden Leiterplatten 2, 3 sind durch eine Steckverbindung, die Toleranz ausgleichend ist, elektrisch miteinander verbunden. Solche Steckverbindungen sind handelsüblich und z.B. von der Firma IRISO erhältlich. Die Steckverbindung umfasst eine Steckbuchse 17, die auf der ersten Leiterplatte 2 befestigt ist, und einen Stecker 18, der auf der zweiten Leiterplatte 3 befestigt ist.

Die Steckbuchse 17, der Stecker 18 und die Öffnung 13 sind so angeordnet, dass sie in montiertem Zustand übereinander sind.

Zur Montage wird die erste Leiterplatte 2 so mittels Schauben an dem Halter 4 befestigt, dass sie der ersten Seite des Bodens 12 gegenüber liegt und dass Strukturen der Antenne nach außen weisen. Die erste Leiterplatte 2 liegt hierbei auf dem entsprechenden Rand des Halters 4 auf und schließt bündig mit dessen Umfang ab. Die Steckbuchse 17 ist von der Gegenseite des Halters 4 durch die Öffnung 13 zugänglich. Die Baugruppen der ersten Leiterplatte 2 befinden sich in den zwischen dem Boden 12, den Stegen 14 und der ersten Leiterplatte 2 gebildeten Kammern.

Anschließend wird die zweite Leiterplatte 3 auf der der ersten Leiterplatte 2 gegenüberliegenden Seite des Halters 4 eingelegt und mittels Schrauben befestigt, wobei der Stecker 18 durch die Öffnung 13 in die Steckbuchse 17 gedrückt wird. Die zweite Leiterplatte 3 befindet sich hierbei innerhalb des Rahmens 4 unter dessen Rand.

Der Halter 4 mit den beiden Leiterplatten 2, 3 wird mit der ersten Leiterplatte 2 nach unten in das Gehäuse 1 gelegt. Hierbei werden die Kontaktdrähte 9 in entsprechende elektrische Anschlussbohrungen gedrückt, die in eine Zunge der zweiten Leiterplatte 3 eingelassen sind. Der Halter wird mit Schrauben in dem Gehäuse 1 befestigt.

Schließlich wird das Gehäuse 1 mit dem Deckel 5 verschlossen, wobei der Kontaktanschluss 15 mit dem Massekontakt 10 kontaktiert; weiterhin ist eine sichere Abschirmung aus dem Deckel 5 mit dem Halter 4 gebildet. Der Deckel 5 wird mittels der Federklammern 6 an dem Gehäuse 1 gesichert.

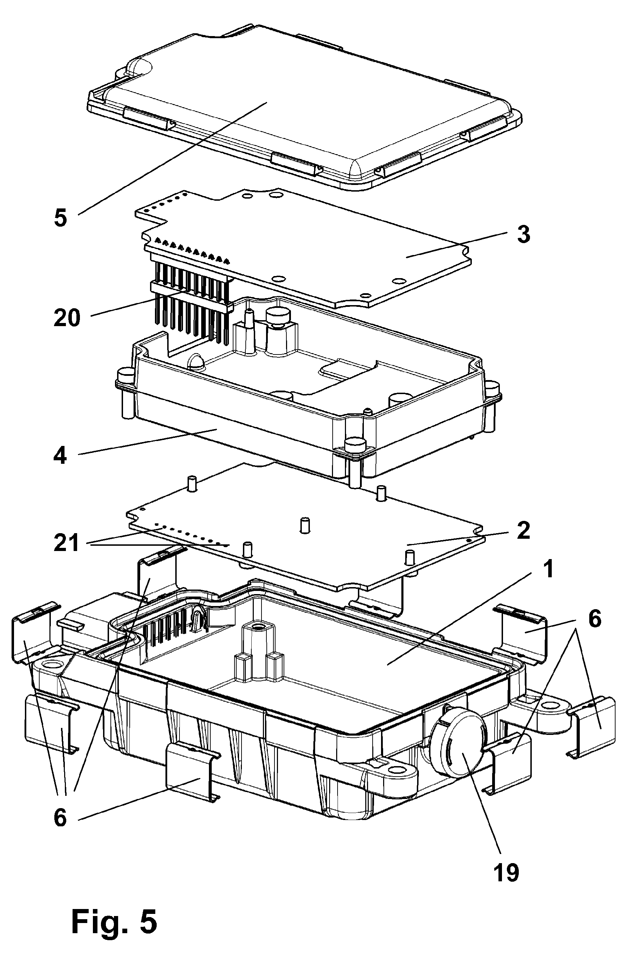

Ein alternatives Ausführungsbeispiel, das in der Figur 5 dargestellt ist, unterscheidet sich von dem oben beschriebenen Beispiel nur durch die Art der Steckverbindung der Leiterplatten 2, 3. Hierfür ist eine Stiftleiste 20 angeordnet, wobei ein erstes Ende jedes Stifts mit der ersten Leiterplatte 2 verlötet ist. Auf der zweiten Leiterplatte 3 sind entsprechende Kontaktbohrungen 21 eingelassen.

Bei der Montage werden hier die Stifte der Stiftleiste 20, die durch die Öffnung 13 ragt, in die Kontaktbohrungen 21 eingepresst, so dass ein sicherer elektrischer Kontakt zwischen den Leiterplatten 2, 3 gewährleistet ist.

### Bezugszeichenliste

- 1: Gehäuse
- 2: erste Leiterplatte
- 3: zweite Leiterplatte
- 4: Halter
- 5: Deckel
- 6: Federklammer
- 7: Buchse
- 8: Ausbuchtung
- 9: Kontaktdraht
- 10: Massekontakt
- 11: Stutzen
- 12: Boden
- 13: Öffnung
- 14: Rippe
- 15: Kontaktanschluss
- 16: Umlaufsteg
- 17: Steckbuchse
- 18: Stecker
- 19: Kappe
- 20: Stiftleiste
- 21: Kontaktbohrung

## Patentansprüche

1. Radarsensor
mit einem Gehäuse (1), das mit einem Deckel (5) verschließbar ist, und mit mindestens einer in dem Gehäuse (1) angeordneten Leiterplatte (2, 3),
**dadurch gekennzeichnet, dass** mindestens eine Antenne auf einer ersten der Leiterplatten (2) angeordnet ist,
dass mindestens eine zweite Leiterplatte (3) angeordnet ist,
wobei die Leiterplatten (2, 3) elektrisch miteinander verbindbar sind,
dass die Leiterplatten (2, 3) an einem metallischen Träger (4) lösbar befestigt sind,
dass der Deckel (5) aus Metall gefertigt ist und mit dem Träger (4) in montiertem Zustand ein Strahlen hemmendes Labyrinth bildet
und dass das Gehäuse (1) aus Kunststoff gefertigt ist.

2. Radarsensor nach Anspruch 1, **dadurch gekennzeichnet, dass** an dem Gehäuse (1) ein Druckausgleichselement angeordnet ist.

3. Radarsensor nach Anspruch 2, **dadurch gekennzeichnet, dass** das Druckausgleichselement mit einer Kappe (19) abdeckbar ist.

4. Radarsensor nach einem der Ansprüche 1 bis 3, **dadurch gekennzeichnet, dass** an dem Gehäuse (1) eine elektrische Buchse (7) mit entsprechenden Kontaktdrähten (9) ausgebildet ist, wobei die Kontaktdrähte (9) als Einpresskontakte mit der zweiten Leiterplatte (3) elektrisch verbindbar sind.

5. Radarsensor nach einem der Ansprüche 1 bis 4, **dadurch gekennzeichnet, dass** an dem Träger (4) Kammern zur Aufnahme von auf den Leiterplatten (2, 3) angeordneten elektrischen Baugruppen ausgebildet sind.

6. Radarsensor nach einem der Ansprüche 1 bis 6, **dadurch gekennzeichnet, dass** die Leiterplatten (2, 3) mittels einer Steckverbindung elektrisch miteinander verbindbar sind.

7. Radarsensor nach Anspruch 6, **dadurch gekennzeichnet, dass** die Steckverbindung Toleranz ausgleichend ausgebildet ist.

8. Radarsensor nach einem der Ansprüche 1 bis 6, **dadurch gekennzeichnet, dass** die Leiterplatten (2, 3) mittels einer Stiftleiste elektrisch miteinander verbindbar sind.

9. Radarsensor nach einem der Ansprüche 1 bis 8, **dadurch gekennzeichnet, dass** die Leiterplatten (2, 3) mittels Schrauben an dem Träger (4) befestigt sind.

10. Radarsensor nach einem der Ansprüche 1 bis 9, **dadurch gekennzeichnet, dass** der Deckel (5) über die Buchse (7) mit einer elektrischen Masse verbindbar ist.
